# EUROPEAN PATENT SPECIFICATION

(11) **EP 2 832 895 B1**
(45) Date of publication and mention of the grant of the patent: **21.08.2019**
(21) Application number: 12872951.4
(22) Date of filing: 14.11.2012
(51) Int. Cl.: C23C 14/34, B21C 1/00, B21C 23/00, B21C 23/08, C22C 5/06, C22F 1/14, H01L 51/50, H05B 33/10, H05B 33/26, C22F 1/00

(54) **SILVER-BASED CYLINDRICAL TARGET**
SILBERBASIERTES ZYLINDRISCHES TARGET
CIBLE CYLINDRIQUE À BASE D'ARGENT

(30) Priority: 27.03.2012 JP 2012071328
(43) Date of publication of application: 04.02.2015
(73) Proprietor: Mitsubishi Materials Corporation, Chiyoda-ku Tokyo 100-8117 (JP)
(72) Inventor: KOMIYAMA, Shozo, Sanda-shi Hyogo 669-1339 (JP)
(74) Representative: Hoffmann Eitle
(86) International application number: PCT/JP2012/079485
(87) International publication number: WO 2013/145424

(56) References cited:
- EP-A1- 1 659 194
- EP-A1- 2 647 737
- WO-A1-2011/043486
- WO-A1-2013/105285
- JP-A- 2004 084 065
- JP-A- 2004 339 585
- JP-A- 2005 036 291
- JP-A- 2009 512 779
- JP-A- 2011 100 719
- US-A1- 2003 052 000
- US-A1- 2005 279 630
- US-A1- 2007 251 819
- US-A1- 2010 059 151
- US-B1- 6 294 738

## Description

### TECHNICAL FIELD

The present invention relates to a silver-based cylindrical target for forming an-electrically conductive film for a reflective electrode of an organic EL element, a wiring film of a tough panel, or the like according to claim 1.

Priority is claimed on Japanese Patent Application No. 2012-071328, filed March 27, 2012.

### BACKGROUND ART

The sputtering target apparatus using a cylindrical target is well suited for film deposition on a large area. In the apparatus, the utilization ratio of the target is very high. Generally, the utilization ratio of a flat plate target is from about several dozen % to 30%. However, in the cylindrical target, a very high utilization ratio, which is about 80%, can be obtained by performing sputtering while the cylindrical target is rotated. In addition, by using the cylindrical target, the film can be formed in a high film deposition rate by applying a high electrical power on the target since cooing efficiency is high in the cylindrical target. Conventionally, the above-explained cylindrical targets have been used mainly in film deposition apparatuses for surface coating on the building material glass, and have not been utilized for manufacturing electronic components, in which a strict control of the film deposition atmosphere is required.

Recently, a rotating-cathode-type sputtering target, which is applicable for manufacturing a large-sized electronic component such as solar panels and flat-panel displays, has been developed, and needs for cylindrical targets are increased.

One of the flat-panel displays is the display using the organic EL element. As a reflective film of the organic EL element, in addition to the aluminum-based reflective film, the silver-based reflective film, which is advantageous for obtaining high brightness and high efficiency of the display panel, is utilized.

In the reflective film of the organic EL element, very high flatness is required. While, in the case where micro-arc discharge occurs during sputtering, the target material is melted locally; and the molten matter turns into droplets to form particles. Occasionally, these particles significantly deteriorate the flatness of the film by reaching to the substrate; and reduce the yield rate of the panels. Particularly in the rotating-cathode-type cylindrical sputtering target, on which a large amount of electrical power is applied, occurrence of micro-arc is promoted. Thus, a cylindrical target with less micro-arc occurrence is needed.

In Patent Literature 1 (PTL 1), a sputtering target is disclosed as a target for TFT display. In the target disclosed in PTL 1, formation of the particles, which deteriorate the production yield during consumption in sputtering, is reduced as much as possible. The target disclosed in PTL 1 is made of a material with at least two phases or at least two constituents having at least one phase with a crystal grain architecture. In the sputtering target disclosed in PTL 1, the diameter ratio of the maximum diameter to the diameter in the perpendicular direction with respect to the maximum diameter is 2 or higher in the crystal grain architecture of at least one phase. Also, the crystal grain architecture has a density of at least 98% with respect to the theoretical density. In addition, products, in which Cu or Ag is used as a based material and a sparingly-soluble phase of Cr, Mo, W, and T is mixed, are disclosed as the material. As a production method, a method of producing a target tube including: producing one or more of a circular column or a cylinder from a target material in the first process; and deforming the above-mentioned material in at least 50% of the deformation rate in the second process, is disclosed. PTL 4 is related to a sputtering target of a particularly fine material.
PTL 5 describes a silver-based sputtering target and a particularly low three-dimensional fluctuation of grain sizes.
PTL 6 is related to a method for fabrication of silver or silver alloy tube stock being substantially free of defects and having a fine grain size

### [Related Art Documents]

### [Patent Literature]

PTL 1: JP 2009-512779
PTL 2: JP 2011-100719
PTL 3: JP 2011-162876
PTL 4: US 2003/025000 A1
PTL 5: EP 1 659 194 A1
PTL 6: US 6 294 738 B1

### DISCLOSURE OF INVENTION

### [Problems to be Solved by the Present Invention]

High reflectivity and high corrosion resistance are needed for the reflective film of the organic EL element in order to reflect light emitted in the organic EL layer. Therefore, reduction of particles during sputtering is more severely required than the case of liquid crystal display production.

The purpose of the present invention is to provide a silver-based cylindrical target, in which particle formation is reduced even further particularly during formation of the reflective film of the organic EL display by sputtering, and a method of producing the target.

### [Means to Solving the Problems]

The inventors of the present invention conducted an intensive study on reduction of the particles during sputtering, and obtained the findings below.

The purpose of the invention described in PTL 1 is reduction of particles in the target in which a sparingly-soluble phase exists (such as Ag-Cr, Ag-Mo, Ag-W, and Ag-Ti). In the invention, the problem is intended to be resolved by forming sufficient bindings between the sparingly-soluble phase and the matrix. However, in the target disclosed in PTL 1, because the specific resistances are different in the materials of the sparingly-soluble phase and the matrix phase; and non-uniformity of the specific resistances exists, micro-arc discharge easily occurs when a high electrical power is applied.

It is found that crystal grains are needed to be re-crystalized in order for the micro-arc discharge to be reduced even further. Since the crystal grains are re-crystallized, the grain shapes become isotropic. In addition, it is found that the micro-arc discharge easily occurs when large numbers of oxygen and non-metallic inclusions are included in the material.

The present invention provides means to solve the problem indicated below based on the above-explained findings.

The present invention is a silver-based cylindrical target having the features of claim 1.

The silver-based cylindrical target is made of pure silver or a single-phase silver alloy. Thus, the specific resistance becomes uniform in the material to make it unfavorable for the micro-arc discharge to occur. When the crystal grains are flattened by having the diameter ratio A/B being out of range of 0.8-1.2, the recesses and protrusions on the sputter surface of the target are increased with the consumption by continuation of sputtering. Thus, micro-arc discharging increases.

Also, when the oxygen content exceeds 100 ppm, or the content of the non-metallic inclusions exceeds 20 ppm, the micro-arc discharge during sputtering occurs notably.

In the silver-based cylindrical target, which is the present invention, an average grain size of the crystal grains may be 30 µm or more and 400 µm or less, and a dispersion of the grain size of the crystal grains may be 20% or less of the average grain size.

In the silver-based cylindrical target, which is the present invention, the silver-based cylindrical target consists of the silver alloy, and the additive component may be at least one selected from a group consisting of Mg, Al, Zn, Ga, Pd, In, Sn, Sb, and Au.

These Mg, Al, Zn, Ga, Pd, In, Sn, Sb, and Au solid-solutes in Ag to suppress growth of crystal grains. By adding at least one of these elements, corrosion resistance and heat resistance of the film formed by sputtering are improved further more.

Among them, Au and Pd are elements that solid-solute in Ag in any content ratio. The amounts of solid-solution in the other elements are: about 5 mass% of Mg at 200°C; about 2.5 mass% of Al at 200°C; about 25.6 mass% of Zn at 200°C; about 8.0 mass% of Ga at 200°C; about 20.1 mass% of In at 300°C; about 6.2 mass% of Sb at 300°C; and about 10.2 mass% of Sn at 200°C. However, when an excessive amount of the elements is added, the reflectivity reduces or the specific resistance increases prohibiting the genuine trait of the silver-based material from being obtained. Thus, it is not preferable.

Also, adding a small amount of an element (elements) other than the above-described elements within a range, in which the added element solid-solutes in silver, does not increase the micro-arc discharge.

Other aspect of the present disclosure is a method of producing a silver-based cylindrical target including the steps of: performing a hot extrusion process in which a silver ingot or an ingot solid-soluting an additive component is subjected to extrusion work into a cylindrical shape in a condition where an extrusion ratio is 4 or more and 15 or less and a material temperature immediately after extrusion is 500°C or higher and 800°C or lower; and cooling a cylindrical body obtained after the step of performing a hot extrusion process to a temperature of 200°C or lower within 10 minutes after extrusion.

The cast structure is destroyed by the hot extrusion process, and miniaturized crystal grains are formed due to dynamic re-crystallization. When the material temperature immediately after extrusion is lower than 500°C, or the extrusion ratio is less than 4, the re-crystallization does not proceeds. When the material temperature immediately after extrusion exceeds 800°C, the average crystal grain size and its dispersion tend to be increased. Thus, it is not preferable. In extrusion work with the extrusion ratio exceeding 15, the extrusion loads increases. Thus, it is not a realistic condition due to restriction of the load capacity of the extrusion container.

In addition, by cooling the cylindrical body to the temperature of 200°C or lower within 10 minutes after extrusion work, growth of crystal grains is suppressed. Thus, a cylindrical target with miniaturized crystal grains can be obtained.

By the cold drawing process, the dimensional accuracy of the cylindrical target can be improved. Also, the crystal grains deformed in the cold working can be miniaturized by re-crystallizing by the heat treatment performed afterward. By performing the production method explained above, a cylindrical target with a high dimensional accuracy can be obtained.

When the drawing working is performed in the reduction ratio less than 20%, the dispersion of the crystal grain sizes after the heat treatment is increased. Also, the micro-arc discharge during sputtering increases. Thus, it is not preferable. When the temperature in the heat treatment is lower than 450°C, the isotropy of the crystal grains decreases. Also, the dispersion of the crystal grain size increases. When the temperature in the heat treatment process exceeds 650°C, the average crystal grain size increases.

As a predetermined time to keep the cylindrical body at 450°C or higher and 650°C or lower in the heat treatment process, 0.5 hour or longer and 2 hours or shorter is preferable. When it is shorter than 0.5 hour, the isotropy of the crystal grains reduces. Also, the dispersion of the crystal grain sizes tends to be increased. Also, when it is longer than 2 hours, the average crystal grain tends to be increased.

### [Effects of the Invention]

According to the present invention, a cylindrical target capable of suppressing the particle formation even further even if a high electrical power is applied during sputtering can be obtained. Particularly, by forming the reflective film for the organic EL display by performing sputtering using this target, products with a high reflectivity and excellent corrosion resistance can be obtained.

### BEST MODE FOR CARRYING OUT THE INVENTION

Silver-based cylindrical targets and methods of producing the targets are explained below as embodiments of the present invention. Unless otherwise indicated, "%" means "mass%" in this specification except for numeric-specific cases.

The silver-based cylindrical target is made of silver or a single-phase silver alloy in which an additive component is solid-soluted. Also, the ratio A/B is 0.8-1.2, when "A" is the diameter of crystal grains in the direction along the central axis of the cylinder in the cross section including the central axis of the cylinder; and "B" is the diameter of crystal grains in the direction perpendicular to the central axis. Also, the oxygen content is 100 ppm or less, and the content of non-metallic inclusions is 20 ppm or less. The size of the cylindrical target is not particularly limited. For example, it may be set to the dimension having: the outer diameter of 145-165 mm; the inner diameter of 135 mm; and the length of 1-3 m.

The additive component used in the case where the target is made of the silver alloy is selected from the group consisting: Mg; Al; Zn; Ga; Pd; In; Sn; Sb; and Au.

By using silver, a high reflectivity and a low resistance can be obtained in the film formed by sputtering. The target becomes very uniform since the target is made of silver or the single-phase silver alloy; and the grain shapes are isotropic. When the crystal grains have the diameter ratio of the diameter A in the direction along the central axis of the cylinder to the diameter B in the direction perpendicular to the central axis, A/B, of less than 0.8 or more than 1.2, the crystal grains are in flat shapes. In such a case, the recesses and protrusions on the sputter surface are increased with the consumption by continuation of sputtering. Thus, micro-arc discharging increases.

When the oxygen content exceeds 100 ppm, the micro-arc discharge during sputtering occurs notably. It is believed that the excess amount oxygen causes local gas emission during sputtering; and the gas emission becomes a source of occurrence of the micro-arc discharge.

When the content of the non-metallic inclusions exceeds 20 ppm, the micro-arc discharge during sputtering occurs notably. It is believed that the non-metallic inclusions are included by entrapping oxides of the refractory part of the furnace or the additive components during melting and casting. And, it is believed that the local existence of the non-metallic inclusions as an insulating body in the electrically conductive material causes occurrence of the micro-arc discharge during sputtering.

Each of the elements of: Mg; Al; Zn; Ga; Pd; In; Sn; Sb; and Au, which is selected as the additive component, solid-solutes in Ag and effectively suppresses growth of crystal grains. In addition, addition of one of the elements increases hardness of the target. Thus, by adding one of the elements, deformation during machining can be effectively suppressed. By adding at least of these elements, corrosion resistance and heat resistance of the film formed by sputtering can be improved further more.

Particularly, addition of In or Sn is effective on improving corrosion resistance and heat resistance of the reflective film of the organic EL element formed by sputtering. This is because the addition of In or Sn causes: reduction of the surface roughness of the film while miniaturizing the crystal grains in the film; and increasing strength of the crystal grains by being solid-soluted in Ag, suppressing coarsening of crystal grains due to heat. Because of this, addition of In or Sn effectively suppresses increasing of the surface roughness of the film and reducing of the reflectivity due to sulfurization of the film.

In the case where one or more of these elements are added, it is preferable that the total additive amount is set to 0.1 mas% or more and 2.5 mass% or less to allow the effect to be exhibited effectively. When an excess amount of an element is added, there is a possibility that the reflectivity of the film or the electrical resistance is reduced.

It is preferable that the average grain size of the crystal grains is 30 µm or more and 400 µm or less, and the dispersion of the grain size of the crystal grains is 20% or less of the average grain size.

Having the average grain size less of than 30 µm is not realistic and introduces unnecessary cost increase. It also causes insufficient re-crystallization. In such a situation, the dispersion of the grain sizes increases and make it hard to suppress the micro-arc discharge. On the other hand, when the average grain size exceeds 400 µm, the recesses and protrusions on the sputter surface are increased with the consumption of the target during sputtering. Thus, micro-arc discharging tends to be increased. When the dispersion exceeds 20% of the average crystal grain size, micro-arc discharging tends to be increased with the consumption of the target during sputtering. A more preferable crystal grain size is less than 250 µm.

In regard to the crystal grains, the diameter ratio of the diameter A in the direction along with the central axis of the cylindrical target to the diameter B in the direction perpendicular to the central axis, the diameter ratio A/B, is measured as explained below. Also, the average crystal grain size and the dispersion of the crystal grain sizes are measured as described below.

Cubic samples whose side is about 10 mm are taken from evenly distributed 16 locations in the sputtering surface of the target. Specifically, samples whose width is about 10 mm in a ring shape are hewn out at four locations evenly distributed in the longitudinal direction along the central axis of the cylindrical target. Then, roughly cubic samples whose side is about 10 mm are taken from each of ring-shaped samples at four locations evenly distributed in the circumferential direction.

Next, each piece of samples is grinded on the cut surface side that is cut in the surface including the central axis of the cylindrical target. In this occasion, the side is subjected buffing with the abrasive coating of 3 µm-1 µm after grinding with the sandpaper of #180-#4000 with a waterproof backing.

Then, the side is etched to the extent in which the grain boundaries can be observed by an optical microscope. As the etching fluid, the mixed liquid of the hydrogen peroxide solution and the ammonia water is used. The grain boundaries are revealed by immersing the sample piece at the room temperature for 1-2 minutes. Next, by using each of samples as observation objects, photographs of 60 times or 120 times magnification are taken with the optical microscope. An appropriate magnification of the photographs is selected based on easiness of counting the crystal grains.

In each photograph, two 60 mm-lines, which are spaced away 20 mm each other, are drawn in the direction along the central axis of the cylindrical target; and the numbers of crystal grains dissected by each of lines are counted. The crystal grain positioned at the end of the line is counted as 0.5 in the counting. The average intercept length L (µm) can be obtained from the formula, L-60000/(M·N) (M is the actual magnification rate, and N is the average of the numbers of the dissected crystal grains).

Next, based on the obtained average intercept length L (µm), the diameter dp (µm) in the direction along with the central axis of the cylindrical target is calculated from the formula, dp=(3/2)·L, in the crystal grains of the sample.

The diameters dp (µm) in crystal grains of each sample taken from 16 locations as explained above are averaged to obtain the averaged value of the diameter, dpa (µm), in the direction along with the central axis of the cylindrical target.

Also, in each photograph, two 60 mm-lines are drawn in the direction perpendicular to the central axis; the diameter dv (µm) in the direction perpendicular to the central axis is calculated in crystal grains of each sample in the same manner; and the average value dva (µm) was obtained.

The diameter ratio R of the diameter in the direction along the central axis of the cylindrical target to the diameter in the direction perpendicular to the central axis in the crystal grains is calculated from the formula, R=dpa/dva.

The average crystal grain size, d (µm) of each sample is calculated as the average value d of the dpa and the dva from the formula, the average value d=(dpa+dva)/2. The average value of d values in 16 locations is defined as the average crystal grain size da (µm) of the target. The dispersion S(%) is calculated as explained below. First, among the 16 average crystal gain sizes obtained in the 16 locations, one with the maximum absolute value of the deviation to the average crystal grain size of the target (|((average grain size at a certain location)-da)|) is specified. Then, by using the specified average crystal grain size (specified average crystal grain size), the dispersion S is calculated from the formula, S=|((specified average crystal grain size)-da)|/da×100.

Next, the method of producing the silver-based cylindrical target is explained as embodiments of the present invention.

### [Casting process]

First, a billet in a circular pillar shape made of silver or a silver alloy is produced by casting. In this case, Ag with purity of 99.99 mass% or higher is used as the material. Ag is melted in a high vacuum or an inert gas atmosphere. When the silver alloy is prepared, an additive component selected from the group consisting: Mg; Al; Zn; Ga; Pd; In; Sn; Sb; and Au is added to the obtained melted metal of Ag in a predetermined content amount first. Then, after the addition, the mixture is molted in a vacuum or an inert gas atmosphere to prepare the melted and casted billet of the silver alloy.

It is preferable to: perform melting of Ag in an atmosphere substituted by argon after making the atmosphere in a vacuum condition; and add the additive component to the melted metal of Ag in the argon atmosphere after melting in a view of stabilization of the composition ratio of Ag and the additive component.

It is preferable that the above-described melting and casting is performed in a vacuum atmosphere or an atmosphere substituted by an inert gas However, a melting furnace in the natural atmosphere. In the case where the melting furnace in the natural atmosphere is used, an inert gas is blown to the surface of the melted metal. Alternatively, melting and casting is performed while the surface of the melted metal is covered by a carbon-based solid sealing material such as charcoal. By following the above-mentioned procedures, the oxygen content or the content of the non-metallic inclusions in the billet can be reduced.

It is preferable that the melting furnace is the induction heating furnace in order to have a uniform constituent.

### [Hot extrusion process]

The circular pillar shaped billet is machined into a dimension capable of being loaded in the container of the extrusion apparatus. At this time, it is preferable that hole-drilling, in which the mandrel of the extrusion apparatus is inserted, is performed in view of reducing the uneven thickness of the silver tube after extrusion.

Next, the obtained billet is heated by the heating furnace and loaded in the container of the extrusion apparatus. The billet is formed in the cylindrical shape by being extruded from the ring-shaped opening formed between the die and the mandrel of the extrusion apparatus. At this time, the heating temperature is adjusted so that the temperature of the cylindrical extruded body (cylindrical body) immediately after being extruded from the space between the die and the mandrel becomes 500°C or higher and 800°C or lower; and extrusion work is performed in the condition where the extrusion ratio is 4 or higher and 15 or lower. The extrusion ratio can be obtained by dividing: the cross-section area of the material in the cylindrical shape or in the circular pillar shape loaded in the extrusion container before extrusion work; with the cross-section area of the cylindrical extruded material after extrusion work.

When the temperature immediately after extrusion is lower than 500°C, re-crystallization becomes insufficient; and it makes it difficult to suppress the micro-arc discharge. Thus, it is not preferable. Also, when the temperature immediately after extrusion is higher than 800°C, the crystal grains after extrusion become coarse; the recesses and protrusions on the sputter surface of the target are increased with the consumption in sputtering with the cylindrical target; and micro-arc discharging increases. Thus, it is not preferable.

When the extrusion ratio is lower than 4, re-crystallization becomes insufficient and it makes it difficult to suppress the micro-arc discharge. When the extrusion ratio exceeds 15, machining itself becomes difficult.

### [Cold process]

Next, the cylindrical body is quickly cooled within 10 minutes after the hot extrusion work to the temperature of 200°C or lower. By cooling the cylindrical body to the temperature of 200°C or lower within 10 minutes, growth of crystal grains after extrusion can be suppressed; and the cylindrical target with miniaturized crystal grains can be obtained. When the time for the cooling takes longer than 10 minutes, it causes coursing of the crystal grains.

As the quick cooking method, water-showering for about 1 minute can be performed.

After cooling, if necessary, the cylindrical target is finished in the predetermined dimension by machining such as the correction process, lathe turning process, or the like. It is preferable that the arithmetic average surface roughness (Ra) of the sputter surface of the finally obtained sputtering target is 0.2-2 µm.

The cylindrical target after machining is bonded to the backing tube and applied to sputtering. In bonding with the backing tube, a long target can be produced by connecting short cylindrical targets. However, the joint line becomes an origination of abnormal discharge. Thus, it is preferable a single piece cylindrical target is bonded.

The silver-based cylindrical target produced as described above is made of silver or the single-phase silver alloy in which the additive component is solid-soluted, wherein the ratio A/B is 0.8-1.2, A being the diameter of crystal grains in the direction along the central axis of the cylinder in the cross section including the central axis of the cylinder; and B being the diameter of crystal grains in a direction perpendicular to the central axis. Thus, the cylindrical target has isotropic crystal grains. Also, in the silver-based cylindrical crystal grain, the average grain size of the crystal grains is 30 µm or more and 400 µm or less, and the dispersion of the grain size of the crystal grains is 20% or less of the average grain size. Thus, the cylindrical target has a fine and uniform structure. Also, the cylindrical target with a small amount of impurities, in which the oxygen content is 100 ppm or less, and the content of non-metallic inclusions is 20 ppm or less, can be obtained.

Therefore, the micro-arc discharge can be suppressed even a high electric power is applied during sputtering; the particle formation can be reduced even further particularly during formation of the reflection film of the organic EL display; and the high quality reflection film with a high reflectivity and a high corrosion resistance can be obtained.

In order to improve the dimensional accuracy of the cylindrical target even further, an additional cold drawing work can be performed after the hot extrusion process being followed by the heat treatment.

### [Cold drawing process]

In the case where the cylindrical body is subjected to the drawing work, for example, when expanding drawing is performed, it is performed by drawing the cylindrical body through the die in the state where a plug is inserted inside of the cylindrical body. In this cold drawing process, by performing the process in the total reduction ratio of 20% or more, uniform re-crystallization can be obtained through the heat treatment process after the drawing process. To avoid breakage of the material in the drawing process, the total reduction ratio of 20 or more can be obtained by perming multiple passes of drawing. In the drawing work in which the total reduction ratio is less than 20%, the dispersion of the crystal grain sizes after the heat treatment increases; and the micro-arc discharge increases during sputtering. Thus, it is not preferable. The total reduction ratio P (%) is obtained from the formula, P=[1-{D2-(D-h)2}/{d2-(d-H)2}]×100, wherein D is the outer diameter of the cylindrical body before drawing, H is thickness before drawing, d is the outer diameter after the final drawing, and h is thickness after the final drawing.

### [Heat treatment process]

The cylindrical body after the drawing work is kept at the temperature of 450°C or higher and 650°C or lower for 0.5 hour or longer and 2 hours or shorter. Through the cold drawing process, the crystal grains are deformed. By performing the heat treatment for the grain crystals to be re-crystallized and miniaturized, the isotropic crystal grains can be obtained.

### [Examples]

### [Comparative Examples 1 and 2]

Ag with purity of 99.99 mass% or more was loaded in a high frequency induction melting furnace installed by a graphite crucible. The total mass was about 700 kg in the melted state. The molten material was casted in a mold made of cast iron.

From the ingot obtained this casting, the shrinkage cavity part was removed; the surfaces having contacted with the mold was removed by machined finishing; and a billet in a cylindrical shape, which had a rough dimension of: the outer dimension of 350 mm; and the length of 470 mm, was obtained as a defect-free part. In Comparative Example 2, this billet without a hole was subjected to extrusion work. On the other hand, in Comparative Example 1, the central part was removed to form a hole of 140 mm; and the billet in the cylindrical shape, which had a dimension of: the outer diameter of 350 mm; the inner diameter of 140 mm; and the length of 470 mm, was subjected to extrusion work.

These billets were heated to 750°C, and loaded in containers of an extrusion apparatus separately; extrusion work was performed; and they were cooled by water-showering. After performing correction, their surfaces were subjected to cutting work in the extent of several mm to produce silver cylindrical bodies. Backing tubes made of stainless were prepared, and the silver cylindrical bodies were bonded to the backing tubes using In solder to obtain the cylindrical targets. The extrusion ratios during the hot extrusion process, the temperatures of the cylindrical bodies immediately after the extrusion, and the times until they were cooled to 200°C or lower were set as indicated in Table 1.

### [Comparative Examples 1 to 12]

Ag with purity of 99.99 mass% or more and each of additive components ware prepared; and they were loaded in a high frequency induction melting furnace installed by a graphite crucible. The total mass was about 400 kg in the melted state.

In melting, Ag was melted first. Then, after Ag was completely melted, the additive component was added in order to obtain the target compositions indicated in Table 1. After stirring sufficiently the melted metal of the alloy by the stirring effect due to induction heating, the alloys were casted in the molds made of cast ion.

From the ingot obtained by casting, billets in the cylindrical shape with the dimension of: the outer diameter of 265 mm; the inner diameter of 140 mm; and the length of 490 mm, were produced. The cylindrical bodies were obtained by subjecting the obtained billets to extrusion work. The extrusion ratios during the hot extrusion process, and the temperatures of the cylindrical bodies immediately after the extrusion were set as indicated in Table 1. Comparative Examples in Table 1, in which the time until they were cooled to 200°C was shown, were cooled by water-showering. Examples not indicated with the time were cooled simply by being left without water cooling. They were subjected to correction: cut; and subjected to cutting work as in Comparative Example 1, to produce the silver alloy cylindrical bodies. They were bonded to backing tubes to obtain the cylindrical targets.

### [Comparative Example 3]

The Ag powder, which had purity of 99.99 mass% or higher and the grain size of 100 µm or less, and the Cr powder, which had purity of 99.9 mass% or higher and the grain size of 100 µm or less, were mixed in the rate indicated in Table 1. Then, the obtained mixture was inserted in a stainless can; degassed; vacuum-encapsulated; and subjected to HIP treatment under the condition of: 150MPa; and 650°C, to produce the AgCr alloy ingot. Then, the cylindrical target was produced in the same manner as Comparative Examples 3-5 and Comparative Examples 1 and 2.

### [Examples 13-15, 17-19 and Comparative Examples 4, 5 and 16]

As in Comparative Examples 3-12 and Comparative Examples 1 and 2, the cylindrical targets were obtained by: performing two passes of cold expanding drawing work after producing the cylindrical body by melting and casting and extrusion work; then performing the heat treatment; and performing machining.

The reduction ratio of the cold drawing work, and temperature and time of the heat treatment were set as indicated in Table 1.

### [Comparative Example 6]

As in Comparative Examples 3-5 and Comparative Examples 1-3 the cylindrical target was produced in the condition indicted in Table 1, except for: using an induction melting furnace in the natural atmosphere in melting of the Ag alloy; not using the inert gas in the set of melting and casting processes; and not covering the surface of melted metal with charcoal or the like.

### [Comparative Example 7]

As in Comparative Examples of 3-5 and Comparative Examples 1-3 except for using a crucible made by firing an aluminous stamp material as the Ag alloy melting crucible, the cylindrical target was produced in the condition indicated in Table 1. The extrusion rate in table 1 should be read as the extrusion ratio as defined on page 15.

**[Table 1]**

| | Additive component (Material) | | Temperature immediately after extrusion (°C) | Extrusion rate | Time to be cooled (min) | Reduction ratio in drawing work (%) | Heat treatment | |
|---|---|---|---|---|---|---|---|---|
| | Type | Amount (mass%) | | | | | Temperature (°C) | Time (hr) |
| C. Ex. 1 | - | - | 570 | 9.8 | 7 | - | - | - |
| C. Ex. 2 | - | - | 670 | 14.9 | 8 | - | - | - |
| C. Ex.1 | Sn | 0.5 | 480 | 6.3 | 6 | - | - | - |
| C. Ex. 3 | In | 1.0 | 510 | 6.3 | 6 | - | - | - |
| C. Ex. 4 | In | 0.5 | 650 | 6.3 | 6 | - | - | - |
| | Sb | 1.0 | | | | | | |
| C. Ex. 5 | Sb | 2.5 | 780 | 6.3 | 6 | - | - | - |
| C. Ex. 6 | In | 1.5 | 830 | 6.3 | 6 | - | - | - |
| C. Ex. 7 | Sn | 0.3 | 590 | 6.3 | None | - | - | - |
| C. Ex. 2 | Sb | 1.5 | 580 | 3.9 | 7 | - | - | - |
| C. Ex. 3 | Cr | 1.5 | 590 | 6.3 | 7 | - | - | - |
| C. Ex. 8 | Sn | 2.3 | 570 | 4.6 | 7 | - | - | - |
| C. Ex. 9 | Mg | 1.0 | 580 | 4.6 | 7 | - | - | - |
| C. Ex. 10 | Al | 0.3 | 580 | 4.6 | 7 | - | - | - |
| | Zn | 0.5 | | | | | | |
| C. Ex. 11 | Ga | 2.3 | 570 | 4.6 | 7 | - | - | - |
| C. Ex. 12 | Au | 1.5 | 580 | 8.4 | 6 | - | - | - |
| Ex. 13 | - | - | 560 | 7.5 | - | 32.3 | 460 | 2.0 |
| Ex. 14 | In | 0.5 | 570 | 7.5 | - | 32.3 | 550 | 1.0 |
| Ex. 15. | Sb | 3.0 | 570 | 7.5 | - | 32.3 | 650 | 0.5 |
| C. Ex. 4 | In | 3.0 | 580 | 7.5 | - | 32.3 | 400 | 1.5 |
| Ex. 16 | In | 0.7 | 580 | 7.5 | - | 32.3 | 700 | 1.0 |
| Ex. 17 | Sn | 3.5 | 540 | 7.0 | - | 22.0 | 580 | 1.0 |
| Ex. 18 | Pd | 1.0 | 550 | 7.0 | - | 22.0 | 630 | 1.0 |
| Ex. 19 | Sn | 1.5 | 550 | 7.0 | - | 22.0 | 530 | 1.5 |
| | Sb | 1.5 | | | | | | |
| C. Ex. 5 | Sn | 1.0 | 540 | 7.0 | - | 18.0 | 500 | 1.0 |
| C. Ex. 6 | Mg | 0.8 | 570 | 7.0 | 6 | - | - | - |
| C. Ex. 7 | Pd | 2.0 | 590 | 7.0 | 6 | - | - | - |

With relation to Table 1 above, C. Ex. 4 are both different comparative examples. Example 16 is also a comparative example. The same comments apply to Table 2.

In regard to the obtained cylindrical targets, isotropy of crystal grains, the average grain size, and the dispersion of the grain size were measured. Also, the oxygen content, and the content of the non-metallic inclusions were measured. Also, after attaching them to the sputtering apparatus, the number of occurrence of micro-arc during sputtering was measured.

### (1) Isotropy of crystal grains, the average grain size, and the dispersion of the grain size

As described in the embodiments of the present invention, samples were taken from the evenly distributed 16 locations from the cylindrical targets produced as explained above. Then, the diameter in the direction along with the central axis of the cylinder and the diameter in the direction perpendicular to the central axis were measured. Based on the above-described measurements, isotropy of crystal grains, the average grain size, and the dispersion of the grain size were calculated.

### (2) The number of occurrence of micro-arc during sputtering

The cylindrical targets produced as explained above were soldered on the stainless backing tubes; and the number of occurrence of micro-arc during sputtering was measured.

In this case, the soldered targets were attached to the sputtering apparatus. After exhaustion to 3×10⁻⁴Pa, sputtering was performed in the condition where the Ar gas pressure was 0.5 Pa; the applied electric power was DC15kW; and the distance between the target and the substrate was 200 mm. The number of occurrence of the micro-arc in the initial 30 minutes was measured. Also, the number of occurrence of the micro-arc was measured in 30 minutes after consumption of the target by performing sputtering for 20 hours intermittently by repeating mock sputtering for 4 hours and exchange of the protection plates. These numbers of occurrence of the micro-arc were counted by the arc-counting function of the DC power supply.

### (3) Reflectivity of the sputter film and specific resistance

The silver sputter film and the silver alloy sputter film were deposited on a glass substrate with the dimension of 30 mm×30 mm in the conditions described above. The absolute reflectivity of the film was measured by a spectrophotometer. The specific resistance of the film was measured by the four probe method. The reflectivities and the specific resistances at the wave length of 550 nm were shown in Table 2.

Results were shown in Table 2 below.

**[Table 2]**

| | Isotropy of the crystal grain shape Grain diameter in the axis direction/grain diameter in the radial direction | Oxygen content (mass ppm) | Content of non-metallic inclusions (mass ppm) | Grain size (µm) | Dispersion of grain sizes (%) | Number of occurrence of micro-arc (times) | | Reflectivity of the film | Specific resistance of the film |
|---|---|---|---|---|---|---|---|---|---|
| | | | | | | Initial stage of usage | After consumption | | |
| C. Ex. 1 | 1.1 | 10 | 3 | 120 | 16 | 3 | 5 | 97.7 | 3.2 |
| C. Ex. 2 | 1.0 | 10 | 3 | 200 | 12 | 4 | 6 | 97.6 | 3.3 |
| C. Ex.1 | 1.5 | 20 | 2 | 40 | 30 | 11 | 33 | 96.7 | 4.2 |
| C. Ex. 3 | 1.2 | 10 | 3 | 60 | 18 | 5 | 7 | 95.9 | 4.5 |
| C. Ex. 4 | 1.0 | 20 | 4 | 180 | 14 | 2 | 6 | 96.1 | 5.1 |
| C. Ex. 5 | 1.0 | 20 | 3 | 350 | 12 | 3 | 10 | 94.2 | 7.0 |
| C. Ex. 6 | 0.9 | 10 | 2 | 440 | 12 | 8 | 24 | 95.5 | 5.9 |
| C. Ex. 7 | 1.1 | 10 | 3 | 410 | 25 | 9 | 22 | 97.2 | 4.0 |
| C. Ex. 2 | 1.5 | 10 | 2 | 230 | 35 | 15 | 36 | 95.3 | 5.8 |
| C. Ex. 3 | 1.8 | 90 | 13 | 150 | 15 | 25 | 238 | 93.2 | 8.2 |
| C. Ex. 8 | 1.1 | 20 | 2 | 120 | 15 | 3 | 3 | 93.8 | 7.8 |
| C. Ex. 9 | 1.1 | 10 | 4 | 140 | 16 | 2 | 4 | 96.1 | 4.8 |
| C. Ex. 10 | 1.1 | 10 | 4 | 130 | 16 | 3 | 4 | 96.6 | 4.3 |
| C. Ex. 11 | 1.2 | 20 | 2 | 110 | 17 | 3 | 5 | 94.0 | 7.3 |
| C. Ex. 12 | 1.0 | 10 | 2 | 140 | 16 | 3 | 4 | 94.7 | 6.5 |
| Ex. 13 | 1.2 | 20 | 2 | 80 | 18 | 4 | 3 | 97.7 | 3.2 |
| Ex. 14 | 1.1 | 10 | 2 | 130 | 14 | 2 | 3 | 96.7 | 4.3 |
| Ex. 15. | 1.1 | 10 | 3 | 300 | 13 | 2 | 4 | 92.5 | 8.9 |
| C. Ex. 4 | 1.8 | 20 | 3 | 120 | 38 | 18 | 29 | 92.7 | 8.6 |
| Ex. 16 | 1.0 | 10 | 2 | 450 | 11 | 2 | 23 | 96.5 | 4.4 |
| Ex. 17 | 1.1 | 10 | 4 | 150 | 16 | 3 | 5 | 91.9 | 9.2 |
| Ex. 18 | 1.0 | 10 | 3 | 170 | 17 | 3 | 7 | 95.4 | 4.6 |
| Ex. 19 | 1.2 | 20 | 3 | 230 | 19 | 7 | 12 | 92.3 | 8.8 |
| C. Ex. 5 | 1.3 | 10 | 2 | 280 | 25 | 9 | 27 | 96.1 | 4.5 |
| C. Ex. 6 | 1.1 | 140 | 15 | 150 | 15 | 30 | 55 | 90.3 | 10.7 |
| C. Ex. 7 | 1.1 | 20 | 24 | 140 | 14 | 26 | 81 | 93.5 | 7.7 |

In the cylindrical target of Examples of the present invention, the crystal grains were isotropic crystal grains, in which the ratios of the diameter A in the direction along with the central axis of the cylinder to the diameter B in the direction perpendicular to the central axis, the diameter ratio A/B, were 0,8 to 1.2. Also, the average grain sizes of the crystal grains were 30 µm or more and 400 µm or less. Also, the dispersion of the grain sizes were 20% or less of the average grain size. Also, in the cylindrical targets of Examples of the present invention, the amount of impurities was low, in which the oxygen content was 100 ppm or less, and the content of non-metallic inclusions was 20 ppm or less. Therefore, the numbers of occurrence of the micro-arc during sputtering were low not only in the initial stage of the usage but also after consumption.

The present invention is not limited by the description of the above-explained embodiments, and can be subjected to a variety of modification without departing from the scope of the present invention.

### INDUSTRIAL APPLICABILITY

The present invention can be utilized for: a silver-based cylindrical target for forming an-electrically conductive film for a reflective electrode of an organic EL element, a wiring film of a tough panel, or the like.

## Claims

1. A silver-based cylindrical target with a cylindrical body consisting of silver or a single-phase silver alloy in which an additive component is so lid-so luted, manufactured by the steps of:
casting a billet of silver or of silver alloy, in which an additive component is solid-soluted in silver, in a circular pillar shape to obtain a silver ingot or silver alloy ingot,
performing a hot extrusion process in which the silver ingot or the silver alloy ingot is subjected to extrusion work to obtain a cylindrical body with a cylindrical shape in a condition where an extrusion ratio is 4 or more and 15 or less and a temperature of the cylindrical body immediately after extrusion is 500°C or higher and 800°C or lower;
performing a cold drawing process in which the cylindrical body obtained after the step of performing a hot extrusion process is subjected to drawing work in a reduction ratio of 20% or more; and
performing a heat treatment process in which the cylindrical body obtained after the step of performing a cold drawing process is kept at a temperature of 450°C or higher and 650°C or lower, wherein a ratio A/B is 0.8-1.2, A being an average diameter of crystal grains in a direction along a central axis of the cylindrical body in a cross section including the central axis of the cylinder; and B being an average diameter of crystal grains in a direction perpendicular to the central axis,
an oxygen content is 100 ppm or less, and
a content of non-metallic inclusions is 20 ppm or less.

## Patentansprüche

1. Silberbasiertes zylindrisches Target mit einem zylindrischen Körper, das aus Silber oder einer einphasigen Silberlegierung besteht, in der eine Additivkomponente festgelöst ist, hergestellt durch die folgenden Schritte:
Gießen eines Rohlings aus Silber oder aus einer Silberlegierung, in der eine Additivkomponente in Silber festgelöst ist, zu einer kreisförmigen Säulenform, um einen Silberbarren oder einen Silberlegierungsbarren zu erhalten,
Durchführen eines Heißextrusionsverfahrens, bei dem der Silberbarren oder der Silberlegierungsbarren einer Extrusionsarbeit unterzogen wird, um einen zylindrischen Körper mit einer zylindrischen Form in einem Zustand zu erhalten, in dem ein Extrusionsverhältnis 4 oder mehr und 15 oder weniger beträgt und eine Temperatur des zylindrischen Körpers unmittelbar nach der Extrusion 500 °C oder mehr und 800 °C oder weniger beträgt;
Durchführen eines Kaltziehprozesses, bei dem der zylindrische Körper, der nach dem Schritt des Durchführens eines Heißextrusionsprozesses erhalten wird, einer Zieharbeit in einem Reduktionsverhältnis von 20 % oder mehr unterzogen wird; und
Durchführen eines Wärmebehandlungsprozesses, bei dem der zylindrische Körper, der nach dem Schritt des Durchführens eines Kaltziehprozesses erhalten wird, bei einer Temperatur von 450 °C oder höher und 650 °C oder niedriger gehalten wird, wobei ein Verhältnis A/B 0,8-1,2 beträgt, wobei A ein durchschnittlicher Durchmesser von Kristallkörnern in einer Richtung entlang einer Mittelachse des zylindrischen Körpers in einem Querschnitt ist, der die Mittelachse des Zylinders einschließt; und wobei B ein durchschnittlicher Durchmesser von Kristallkörnern in einer Richtung senkrecht zur Mittelachse ist,
wobei ein Sauerstoffgehalt 100 ppm oder weniger beträgt und
ein Gehalt an nichtmetallischen Einschlüssen 20 ppm oder weniger beträgt.

## Revendications

1. Cible cylindrique à base d'argent dotée d'un corps cylindrique constitué d'argent ou d'un alliage d'argent monophasé dans lequel un composant additif est en solution solide, fabriqué par les étapes suivantes :
coulage d'une billette d'argent ou d'alliage d'argent, dans laquelle un composant additif est en solution solide dans l'argent, sous forme de colonne circulaire pour obtenir un lingot d'argent ou un lingot d'alliage d'argent,
réalisation d'un procédé d'extrusion à chaud dans lequel on soumet le lingot d'argent ou le lingot d'alliage d'argent à un travail d'extrusion pour obtenir un corps cylindrique d'une forme cylindrique dans une condition où un rapport d'extrusion est supérieur ou égal à 4 et inférieur ou égal à 15 et une température du corps cylindrique immédiatement après extrusion est supérieure ou égale à 500 °C et inférieure ou égale à 800 °C ;
réalisation d'un procédé d'étirage à froid dans lequel on soumet le corps cylindrique obtenu après l'étape de réalisation d'un procédé d'extrusion à chaud à un travail d'étirage dans un rapport de réduction supérieur ou égal à 20 % ; et
réalisation d'un procédé de traitement thermique dans lequel on maintient le corps cylindrique obtenu après l'étape de réalisation d'un procédé d'étirage à froid à une température supérieure ou égale à 450°C et inférieure ou égale à 650°C, dans lequel un rapport A/B va de 0,8 à 1,2, A étant un diamètre moyen des grains de cristal dans une direction qui longe un axe central du corps cylindrique dans une section transversale comprenant l'axe central du cylindre ; et B étant un diamètre moyen des grains de cristal dans une direction perpendiculaire à l'axe central,
une teneur en oxygène est inférieure ou égale à 100 ppm, et
une teneur en inclusions non métalliques est inférieure ou égale à 20 ppm.
